# EUROPEAN PATENT APPLICATION

(11) **EP 2 328 196 A2**
(43) Date of publication of application: **01.06.2011**
(21) Application number: 10192499.1
(22) Date of filing: 25.11.2010
(51) Int. Cl.: H01L 51/52

(54) **Organic light emitting diode display and method of manufacturing the same**

(30) Priority: 25.11.2009 KR 20090114802
(71) Applicant: Samsung Mobile Display Co., Ltd., Yongin-city, Gyunggi-do 446-711 (KR)
(72) Inventor: Bae, Sung-Jin, Gyunggi-Do (KR); Lee, Kyung-Jun, Gyunggi-Do (KR)
(74) Representative: Gulde Hengelhaupt Ziebig & Schneider

(57) **Abstract**

The present invention relates to an organic light emitting diode (OLED) display and a method of manufacturing the same. According to one embodiment of the invention, the OLED display includes: a substrate main body; an OLED that is formed on the substrate main body; and an encapsulation thin film comprising or consisting of a hydrophilic polymer layer that is formed on the substrate main body to cover the OLED and that includes a hydrophilic surface having an angle of contact within a range of larger than 0° and smaller than or equal to 50°; and an inorganic protective layer that is formed on the hydrophilic surface of the hydrophilic polymer layer.

## Description

### BACKGROUND

### 1. Field

The described technology relates generally to an organic light emitting diode (OLED) display and a method of manufacturing the same. More particularly, the described technology relates generally to an OLED display and a method of manufacturing the same that include an encapsulation thin film.

### 2. Description of the Related Art

An OLED display is a self-luminance display device that displays an image using an OLED that emits light. The light results from energy that is generated when excitons that are generated by coupling of electrons and holes within an organic emission layer drop from an excited state to a ground state, whereby the OLED display displays an image. However, because the organic emission layer is sensitive to external factors such as moisture or oxygen, when the organic emission layer is exposed to moisture and oxygen, there is a problem in that quality of the OLED display deteriorates. Therefore, in order to protect an OLED and to prevent moisture or oxygen from penetrating to the organic emission layer, an encapsulation substrate is sealed and adhered through an additional sealing process, or a thick protective layer is formed on the OLED.

However, when using an encapsulation substrate or when forming a protective layer, in order to completely prevent moisture or oxygen from penetrating to the organic emission layer, a process of manufacturing an OLED display is complicated and it is difficult to form the overall thickness of the OLED display to be thin.

The above information disclosed in this Background section is only for enhancement of understanding of the background of the described technology and therefore it may contain information that does not form the prior art that is already known in this country to a person of ordinary skill in the art.

### SUMMARY

Aspects of the invention provide an OLED display including an encapsulation thin film that effectively improves resistance to penetration of moisture and oxygen.

Aspects of the invention provide a method of manufacturing an OLED display including the encapsulation thin film.

An embodiment provides an OLED display including: a substrate main body; an OLED that is formed on the substrate main body; and an encapsulation thin film comprising or consisting of a hydrophilic polymer layer that is formed on the substrate main body to cover the OLED and that includes a hydrophilic surface having an angle of contact within a range of larger than 0° and smaller than or equal to 50°; and an inorganic protective layer that is formed on the hydrophilic surface of the hydrophilic polymer layer.

Another embodiment provides an OLED display including: a substrate main body; an OLED that is formed on the substrate main body; and an encapsulation thin film comprising or consisting of an inorganic protective layer that is formed on the substrate main body to cover the OLED; and a hydrophilic polymer layer that is formed on the inorganic protective layer and that includes a hydrophilic surface having an angle of contact within a range of larger than 0° and smaller than or equal to 50°.

According to an aspect of the invention, the hydrophilic surface of the hydrophilic polymer layer may have a root mean square (RMS) within a range of larger than 0nm and smaller than 3nm.

According to an aspect of the invention, the hydrophilic polymer layer may include or consists of at least one of an acryl-based resin, an epoxy-based resin, polyimide, and polyethylene.

According to an aspect of the invention, the inorganic protective layer may include or consists of at least one of aluminum oxide (Al₂O₃), silicon oxide (SiO₂), silicon nitride (SiNx), silicon nitrate (SiON), magnesium oxide (MgO), fluoride magnesium (MgF₂), indium oxide (ln₂O₃), zinc oxide (ZnO), and tin oxide (SnO₂).

Yet another embodiment provides a method of manufacturing an OLED display, the method including: preparing a substrate main body; forming an OLED on the substrate main body; forming a polymer layer that covers the OLED on the substrate main body; and forming an encapsulation thin film by: forming a hydrophilic polymer layer having a hydrophilic surface by applying ultraviolet rays (UV) and ozone (O₃) to the polymer layer through UV and ozone radiation equipment; thermal curing the hydrophilic polymer layer; and forming an inorganic protective layer on the hydrophilic surface of the hydrophilic polymer layer.

Yet another embodiment provides a method of manufacturing an OLED display, the method including: preparing a substrate main body; forming an OLED on the substrate main body; and forming an encapsulation thin film by: forming an inorganic protective layer that covers the OLED on the substrate main body; forming a polymer layer on the inorganic protective layer; forming a hydrophilic polymer layer having a hydrophilic surface by applying UV and ozone (O₃) to the polymer layer through UV and ozone radiation equipment; and thermal curing the hydrophilic polymer layer.

According to an aspect of the invention, the UV may have a wavelength within a range of 150nm to 280nm.

According to an aspect of the invention, the UV may have energy within a range of 2000mJ/cm² to 3500mJ/cm².

According to an aspect of the invention, the UV and the ozone may be applied to the polymer layer for a time period within a range of 1.5 minutes to 15 minutes.

According to an aspect of the invention, the UV and ozone radiation equipment may radiate first UV rays having a wavelength within a range of 180nm to 190nm and second UV rays having a wavelength within a range of 248nm to 259nm.

According to an aspect of the invention, the UV and ozone radiation equipment may generate oxygen atoms (O) by decomposing oxygen molecules (O₂) with the first UV rays, and generates ozone (O₃) by coupling the oxygen atoms (O) with the second UV rays.

According to an aspect of the invention, the UV rays and the ozone (O₃) that are generated in the UV and ozone radiation equipment may etch a surface of the polymer layer with an average speed within a range of 1 nm/min to 10nm/min.

According to an aspect of the invention, the etch-rate of a portion having a high surface among the surface of the polymer layer may be relatively higher than that of a portion having a low surface.

According to an aspect of the invention, the hydrophilic polymer layer may have an RMS within a range of larger than 0nm and smaller than 3nm.

According to an aspect of the invention, the thermal curing may be performed for 30 minutes to 30 hours at a temperature within a range of 100°C to 160°C.

According to an aspect of the invention, the polymer layer may be formed with a spin coating method.

According to an aspect of the invention, the inorganic protective layer may be formed through an electron beam evaporation (e-beam evaporation) method or an atomic layer deposition (ALD) method.

According to an aspect of the invention, the method may further include preliminarily curing the polymer layer.

According to an aspect of the invention, the preliminary curing may be performed for a time period within a range of 2 minutes to 5 minutes at a temperature within a range of 60°C to 100°C.

According to exemplary embodiments, the OLED display can effectively improve resistance to penetration of moisture and oxygen through an encapsulation thin film.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a cross-sectional view of an OLED display according to an exemplary embodiment.
FIG. 2 is a cross-sectional view illustrating an angle of contact of a hydrophilic polymer layer of FIG. 1.
FIG. 3 is a layout view illustrating a pixel circuit of the OLED display of FIG. 1.
FIG. 4 is a cross-sectional view illustrating a section taken along line IV-IV of FIG. 3.
FIG. 5 is a flowchart illustrating a process of a method of manufacturing an OLED display according to an exemplary embodiment.
FIGS. 6 to 8 are graphs and pictures comparing experimental examples and comparative examples according to an exemplary embodiment.
FIG. 9 is a cross-sectional view of an OLED display according to an exemplary embodiment.
FIG. 10 is a flowchart illustrating a process of a method of manufacturing an OLED display according to an exemplary embodiment.

### DETAILED DESCRIPTION

Reference will now be made in detail to the present embodiments of the present invention, examples of which are illustrated in the accompanying drawings, wherein like reference numerals refer to the like elements throughout. The embodiments are described below in order to explain the present invention by referring to the figures.

Further, like reference numerals designate like elements throughout the specification. In exemplary embodiments other than the exemplary embodiment among several exemplary embodiments, elements different from those of the exemplary embodiment will be described. The size and thickness of each of elements that are displayed in the drawings are described for better understanding and ease of description, and the embodiment is not limited by the described size and thickness.

In the drawings, the thickness of layers, films, panels, regions, etc., are exaggerated for clarity. In the drawings, for better understanding and ease of description, thicknesses of some layers and areas are excessively displayed. It will be understood that when an element such as a layer, film, region, or substrate is referred to as being "on" another element, it can be directly on the other element or intervening elements may also be present.

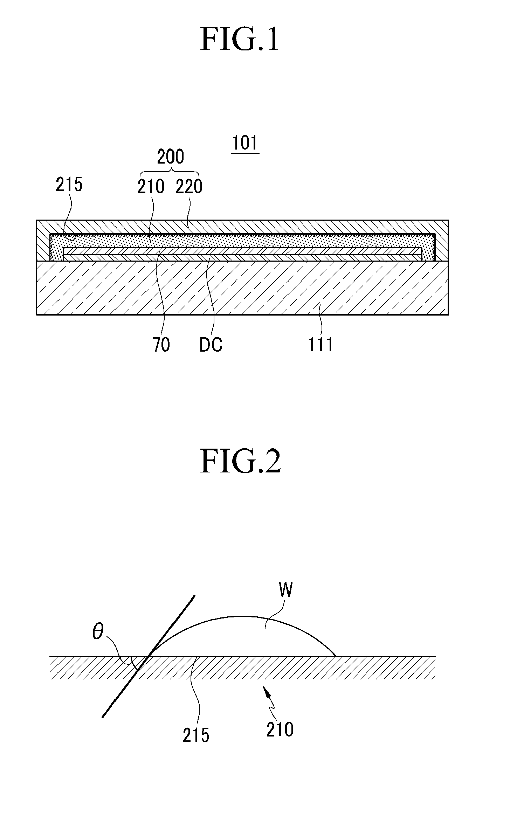

Hereinafter, an OLED display 101 according to an exemplary embodiment will be described with reference to FIGS. 1 to 6. As shown in FIG. 1, the OLED display 101 includes a substrate main body 111, a driving circuit DC, an OLED 70, and an encapsulation thin film 200. The substrate main body 111 can formed as an insulation substrate that is formed of glass, quartz, ceramic, etc., but the invention is not limited thereto. For instance, the substrate main body 111 can formed as a flexible substrate that is formed of plastic, etc. Further, the substrate main body 111 may be formed as a metal substrate that is formed of stainless steel, etc.

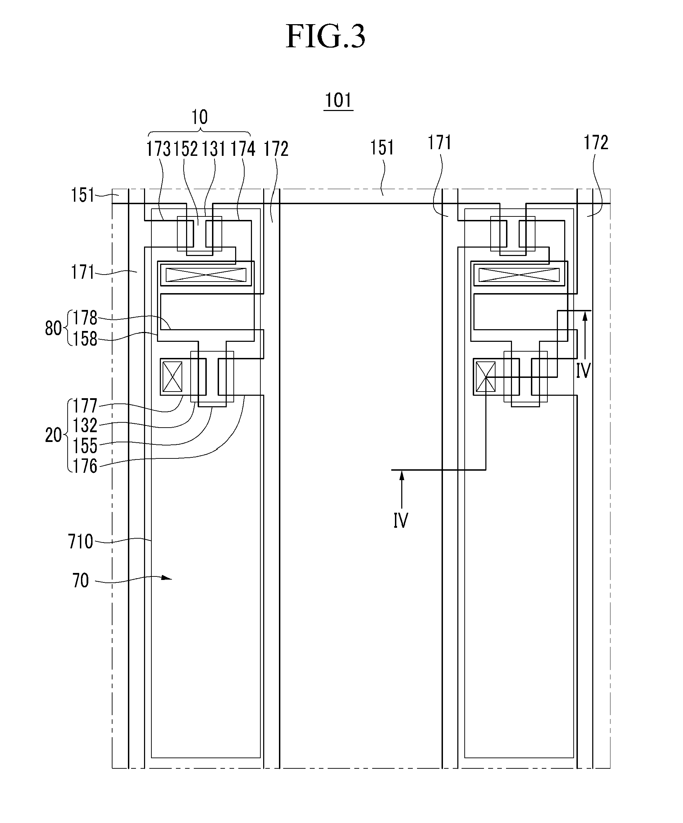

The driving circuit DC and the OLED 70 are formed on the substrate main body 111. The driving circuit DC includes thin film transistors 10 and 20 (shown in FIG. 3) and drives the OLED 70. The OLED 70 emits light according to a driving signal that is received from the driving circuit DC. The encapsulation thin film 200 protects the driving circuit DC and the OLED 70 and suppresses moisture or oxygen from penetrating to an organic emission layer of the OLED 70. The encapsulation thin film 200 includes a hydrophilic polymer layer 210 and an inorganic protective layer 220. The hydrophilic polymer layer 210 is formed directly on the substrate main body 111 and covers the OLED 70.

As shown in FIG. 2, the hydrophilic polymer layer 210 includes a hydrophilic surface 215 having an angle of contact 6 within a range of larger than 0° and smaller than or equal to 50°. The angle of contact θ is an angle when liquid forms a thermodynamic equilibrium on a solid surface. That is, the angle of contact 6 is an angle that is formed by a liquid W on the hydrophilic surface 215 of the hydrophilic polymer layer 210. Further, the angle of contact θ can be measured through a contact angle analyzer. A method of measuring an angle of contact θ includes various well-known methods such as a Sessil drop method, a Wilhelmy plate method, a tilting method, and a captive drop method.

The hydrophilic surface 215 has a surface roughness with a root mean square (RMS) within a range of larger than 0nm and smaller than 3nm. The RMS can be measured using various well-known methods, such as a method of using an atomic microscope (AFM). Further, the hydrophilic polymer layer 210 includes or consists of at least one of an acryl-based resin, an epoxy-based resin, polyimide, and polyethylene.

The inorganic protective layer 220 is formed directly on the hydrophilic surface 215 of the hydrophilic polymer layer 210. The inorganic protective layer 220 includes or consists of aluminum oxide (Al₂O₃), silicon oxide (SiO₂), silicon nitride (SiNx), silicon nitrate (SiON), magnesium oxide (MgO), magnesium fluoride (MgF₂), indium oxide (In₂O₃), zinc oxide (ZnO), tin oxide (SnO₂) or combinations thereof.

The inorganic protective layer 220 primarily suppresses penetration of moisture and oxygen. A thin film of the inorganic protective layer 220 has a density that is relatively larger than that of the hydrophilic polymer layer 210. Therefore, a considerable amount of moisture and oxygen is intercepted by the inorganic protective layer 220.

Moisture and oxygen that pass through the inorganic protective layer 220 are secondarily intercepted by the hydrophilic polymer layer 210. The hydrophilic surface 215 of the hydrophilic polymer layer 210 contacts the inorganic protective layer 220 and has a relatively lower angle of contact and RMS. Therefore, the hydrophilic polymer layer 210 has relatively excellent resistance to penetration of moisture and oxygen, compared with a general polymer layer.

Further, the hydrophilic surface 215 largely improves interface adhesive strength with the inorganic protective layer 220. Therefore, overall reliability of the encapsulation thin film 200 can be largely improved. Also, the hydrophilic polymer layer 210 performs a function of a buffering layer that reduces stress between layers according to bending of the OLED display 101, as well as the function of intercepting moisture and oxygen. Particularly, when a flexible substrate is used as the substrate main body 111, when the OLED display 101 is entirely flexibly formed, the hydrophilic polymer layer 210 performs a buffering function of a bending stress. However, it is understood that the polymer layer 210 need not perform the buffering function in all aspects, such as where the OLED display 101 is not flexible.

Moreover, the hydrophilic polymer layer 210 is formed through a spin coating method. Therefore, a surface of the encapsulation thin film 200 can be entirely planarized. Accordingly, scattering of light that transmits through the encapsulation thin film 200 can be minimized and uniformly dispersed.

By such a structure, the OLED display 101 can effectively improve resistance to penetration of moisture or oxygen through the encapsulation thin film 200.

The encapsulation thin film 200 improves interface adhesive strength due to the hydrophilic surface 215 of the hydrophilic polymer layer 210, thereby having overall improved reliability.

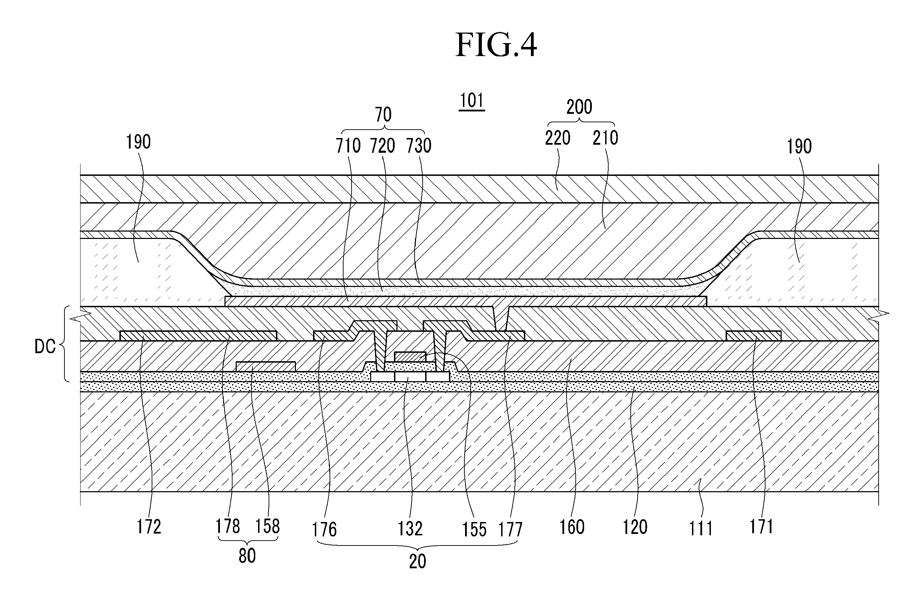

Hereinafter, an internal structure of the OLED display 101 will be described in detail with reference to FIGS. 3 and 4. In FIGS. 3 and 4, an active matrix (AM) OLED display 101 is described using a 2Tr-1Cap structure having two thin film transistors (TFT) 10 and 20 and one capacitor 80 in one pixel. However, the OLED display 101 is not limited thereto. Therefore, the OLED display 101 can have three or more TFTS and two or more capacitors in one pixel, and may have various structures as separate wiring is further formed. Here, a pixel is a minimum unit that displays an image, and is disposed at each pixel area. The OLED display 101 displays an image through a plurality of pixels.

As shown in FIGS. 3 and 4, the switching TFT 10, the driving TFT 20, the capacitor 80, and an OLED 70 are each formed in each pixel on the substrate main body 111. Here, a configuration including the switching TFT 10, the driving TFT 20, and the capacitor 80 is referred to as a driving circuit (DC). A buffer layer 120 is further formed between the substrate main body 111, the driving circuit DC, and the OLED 70. The buffer layer 120 can be formed in a single layer structure of silicon nitride (SiNx), or a dual-layer structure in which silicon nitride (SiNx) and silicon oxide (SiO₂) are stacked. The buffer layer 120 performs a function of planarizing a surface while preventing penetration of an unnecessary component such as an impure element or moisture. However, the buffer layer 120 is not always a necessary element, and may be omitted according to a kind and process conditions of the substrate main body 111.

A gate line 151 is disposed on the substrate body 111 in one direction. A data line 171 and a common power source line 172 are insulated from and intersect the gate line 151 and are formed on the substrate main body 111. A pixel is defined by the gate line 151, the data line 171, and the common power source line 172 as a boundary, but a pixel is not limited thereto.

The OLED 70 includes a first electrode 710, an organic emission layer 720 that is formed on the first electrode 710, and a second electrode 730 that is formed on the organic emission layer 720. Holes and electrons are injected into the organic emission layer 720 from the first electrode 710 and the second electrode 730, respectively. When exitons that are formed by the coupling of the injected holes and electrons drop from an excited state to a ground state, light is emitted.

The capacitor 80 includes a pair of capacitor plates 158 and 178. An interlayer insulating layer 160 is interposed between the capacitor plates 158 and 178. Here, the interlayer insulating layer 160 is a dielectric material. A capacitor capacity is determined by charges that are stored in the capacitor 80 and a voltage between both capacitor plates 158 and 178.

The switching TFT 10 includes a switching semiconductor layer 131, a switching gate electrode 152, a switching source electrode 173, and a switching drain electrode 174. The driving TFT 20 includes a driving semiconductor layer 132, a driving gate electrode 155, a driving source electrode 176, and a driving drain electrode 177.

The switching TFT 10 is used as a switch that selects a pixel to emit light. The switching gate electrode 152 is connected to the gate line 151. The switching source electrode 173 is connected to the data line 171. The switching drain electrode 174 is separated from the switching source electrode 173 and is connected to one capacitor plate (158 in this case).

The driving TFT 20 applies a driving power source for allowing the light to be emitted from the organic emission layer 720 of the OLED 70 within the selected pixel to the pixel electrode 710. The driving gate electrode 155 is connected to the capacitor plate 158 that is connected to the switching drain electrode 174. The driving source electrode 176 and the other capacitor plate 178 are each connected to the common power source line 172. The driving drain electrode 177 is connected to the pixel electrode 710 of the OLED 70 through a contact hole.

By such a structure, the switching TFT 10 operates by a gate voltage that is applied to the gate line 151 and thus performs a function of transferring a data voltage that is applied to the data line 171 to the driving TFT 20. A voltage is stored in the capacitor 80. The voltage corresponds to a difference between a common voltage that is applied from the common power source line 172 to the driving TFT 20 and a data voltage that is transferred from the switching TFT 10. A current corresponding to the voltage that is stored in the capacitor 80 flows to the OLED 70 through the driving TFT 20, whereby the OLED 70 emits light.

The encapsulation thin film 200 including the hydrophilic polymer layer 210 and the inorganic protective layer 220 that are sequentially stacked is formed on the OLED 70. Further, the structure of the TFTS 10 and 20 and the OLED 70 is not limited to the structure that is shown in FIGS. 3 and 4. That is, a structure of the TFTS 10 and 20 and the OLED 70 can be variously changed within a range that can be easily executed by a person of ordinary skill in the art.

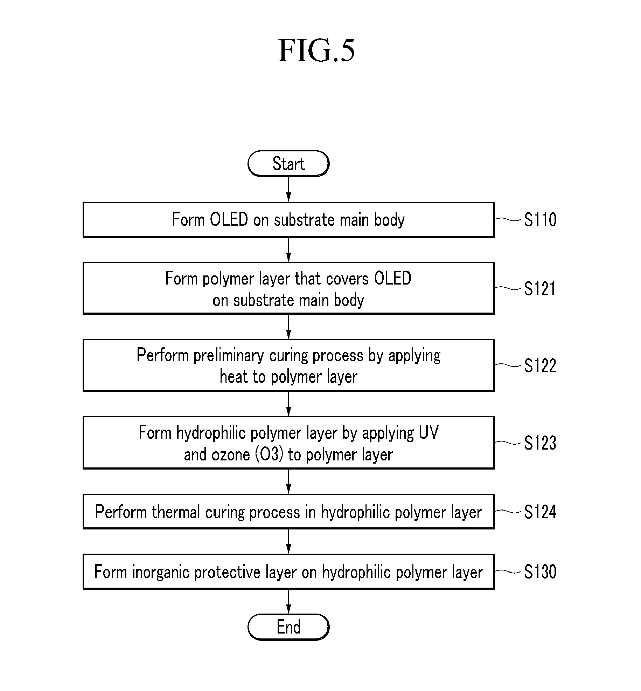

Hereinafter, a method of manufacturing the OLED display 101 of FIG. 1 will be described with reference to FIGS. 1 and 5. A substrate main body 111 is prepared. While not limited thereto, the substrate main body 111 can be formed with glass, quartz, ceramic, or plastic is prepared.

A driving circuit DC and the OLED 70 are formed on the substrate main body 111 (S110). A polymer layer is formed on the substrate main body 111 and covers the OLED 70 (S121). The polymer layer is made of a material including or consisting of at least one of an acryl-based resin, an epoxy-based resin, polyimide, and polyethylene. According to an aspect of the invention, the polymer layer is formed by a spin coating method. Therefore, the polymer layer has a flat surface. However, it is understood other methods can be used to provide a flat surface.

By applying heat to the polymer layer, a preliminary curing process is performed (S122). Such a preliminary curing process may be omitted, as needed. Preliminary curing can be performed using a hot plate. Specifically, preliminary curing is performed for a time period within a range of 2 minutes to 5 minutes at a temperature within a range of 60°C to 100°C. In the exemplary embodiment, as an example, a polymer layer is preliminarily cured for 3 minutes at a temperature of 80°C.

Next, UV and ozone (O₃) are applied to the preliminarily-cured polymer layer through UV and ozone radiation equipment (S123). In this case, the UV rays have a wavelength within a range of 150nm to 280nm and energy within a range of 2000mJ/cm² to 3500mJ/cm². UV and ozone are applied to the polymer layer for a time period within a range of 1.5 minutes to 15 minutes.

The UV and ozone radiation equipment can radiate first UV rays having a wavelength within a range of 180nm to 190nm and second UV rays having a wavelength within a range of 248nm to 259nm. The first UV rays generate oxygen atoms (O) by decomposing oxygen molecules (O₂), and the second UV rays generate ozone (O₃) by coupling the generated oxygen atoms (O). That is, the first UV rays and the second UV rays that are emitted from the UV and ozone radiation equipment generates ozone (O₃) to be applied to the polymer layer while directly light-curing the polymer layer.

By way of example, the first UV rays having a wavelength of about 184.9nm decomposes oxygen molecules (O₂), and the second UV rays having a wavelength of about 253.7nm generate ozone (O₃). Here, the second UV rays have an important influence on curing of the polymer layer.

Further, as an example, UV rays having energy of 2800mJ/cm² are radiated, and UV rays and ozone are applied to the polymer layer for 5 minutes.

In this way, the polymer layer to which UV rays and ozone are applied is etched with an average speed within a range of 1 nm/min to 10nm/min. As an example, the polymer layer is etched for 5 minutes with an average speed of 5nm/min. In this case, an etch-rate of a portion having a high surface in a surface of the polymer layer is relatively faster than that of a portion having a low surface. Therefore, a surface of the polymer layer becomes smooth by being etched and thus becomes a hydrophilic polymer layer 210 having a hydrophilic surface 215.

Next, the hydrophilic polymer layer 210 is thermally cured using an oven (S124). The hydrophilic polymer layer 210 that is thermally cured in the oven is completely cured. Thermal curing is performed for 30 minutes to 30 hours at a temperature within a range of 100°C to 160°C. In the exemplary embodiment, as an example, the hydrophilic polymer layer 210 is thermally cured for 2 hours at a temperature of 120°C.

The hydrophilic polymer layer 210 that is formed in this way has an angle of contact within a range that is larger than 0° and smaller than or equal to 50°. Further, a surface roughness of the hydrophilic polymer layer 210 has an RMS within a range of larger than 0nm and smaller than 3nm.

According to an exemplary embodiment, the hydrophilic polymer layer 210 can have a relatively smooth surface and a low angle of contact. Therefore, the hydrophilic polymer layer 210 can improve resistance to penetration of moisture and oxygen and improve interface adhesive strength.

The inorganic protective layer 220 is formed on the hydrophilic surface 215 of the hydrophilic polymer layer 210 (S130). The inorganic protective layer 220 includes or consists of at least one of aluminum oxide (Al₂O₃), silicon oxide (SiO₂), silicon nitride (SiNx), silicon nitrate (SiON), magnesium oxide (MgO), magnesium fluoride (MgF₂), indium oxide (In₂O₃), zinc oxide (ZnO), and tin oxide (SnO₂). The inorganic protective layer 220 is formed through an e-beam evaporation method or an ALD method. Accordingly, the inorganic protective layer 220 is formed to have a higher density to increase resistance to penetration of moisture and oxygen.

By such a manufacturing method, the OLED display 101 can be manufactured including the encapsulation thin film 200 in which resistance to penetration of moisture and oxygen is effectively improved.

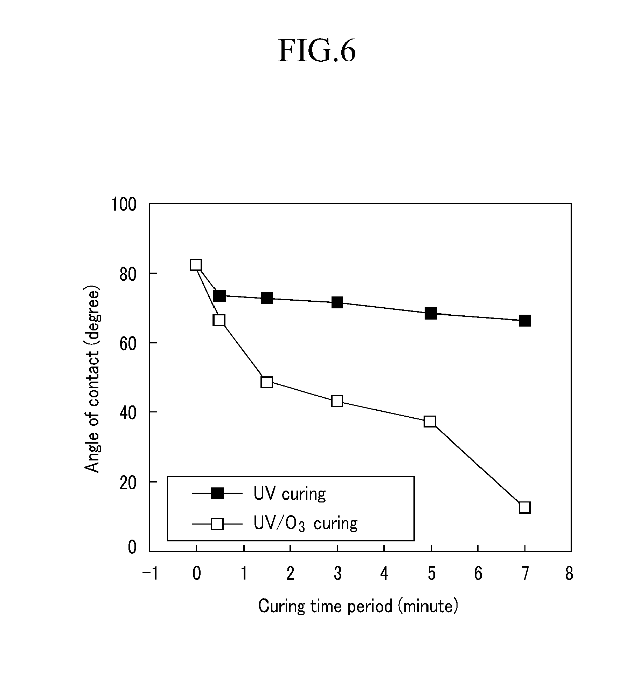

Hereinafter, exemplary embodiments and comparative examples according to the exemplary embodiment will be described through Experiments 1 to 3 with reference to FIGS. 6 to 8. FIG. 6 is a graph illustrating each surface contact angle of experimental examples and comparative examples according to the exemplary embodiment through Experiment 1 that measures an angle of contact.

The experimental examples of Experiment 1 are hydrophilic polymer layers that are formed by a method of preliminarily curing for 3 minutes at a temperature of 80°C, applying first UV rays having a wavelength of about 184.9nm, applying ozone (O₃) and second UV rays having a wavelength of about 253.7nm, and thermal curing for 2 hours at a temperature of 120°C according to the exemplary embodiment. In this case, the used UV has energy of 2800mJ/cm². An applied time period of UV and ozone (O₃) was changed to 1.5 minutes, 3 minutes, and 5 minutes.

Comparative examples of Experiment 1 are polymer layers that are formed with the same process conditions as that of the experimental examples, except for the curing by only the first UV rays. In contrast, the experimental examples according to the exemplary embodiment use ozone (O₃) that is formed through the second UV rays.

As shown in FIG. 6, when UV rays and ozone are applied to a polymer layer for more than 1.5 minutes according to the exemplary embodiment, the angle of contact is relatively much lower as compared to the comparative examples.

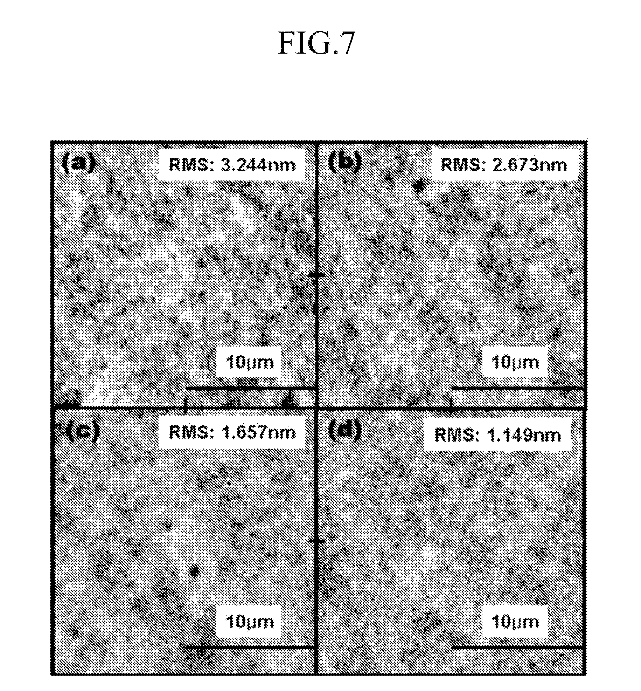

FIG. 7 shows pictures (a) through (d) illustrating each RMS of an experimental example and comparative examples according to the exemplary embodiment through Experiment 2 that measures an RMS. Experimental examples of Experiment 2 were formed with almost the same conditions as those of the experimental examples of Experiment 1, and comparative examples of Experiment 2 were formed with almost the same conditions as those of the comparative examples of Experiment 1.

Specifically, (a) represents an RMS of a comparative example of Experiment 2. The comparative example has an RMS of more than 3nm, and the RMS has little difference according to UV radiation time period. (b) represents an RMS of Experimental Example 1 of Experiment 2 that applies UV and ozone (O₃) for 1.5 minutes according to the exemplary embodiment. (c) represents an RMS of Experimental Example 2 of Experiment 2 that applies UV and ozone (O₃) for 3 minutes according to the exemplary embodiment. (d) represents an RMS of Experimental Example 3 of Experiment 2 that applies UV and ozone (O₃) for 5 minutes according to the exemplary embodiment. As shown in FIG. 7, the experimental examples of Experiment 2 according to the exemplary embodiment have an RMS smaller than 3nm. Further, as an applied time period of UV and ozone (O₃) increases, the RMS is rapidly lowered.

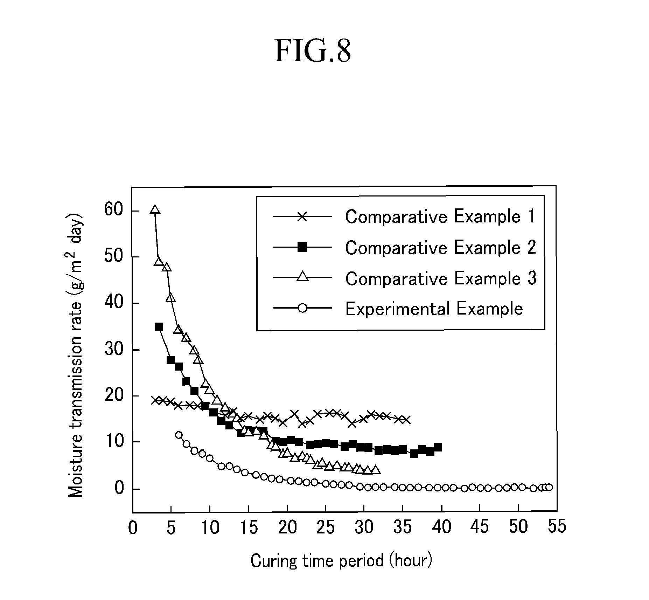

FIG. 8 is a graph illustrating each moisture transmission rate of an experimental example and comparative examples according to the exemplary embodiment through Experiment 3 that measures the moisture transmission rate. The experimental example of Experiment 3 is an encapsulation thin film including the same hydrophilic polymer layer as that of Experimental Example 3 of Experiment 2, and an inorganic protective layer that is formed thereon. Comparative Example 1 of Experiment 3 is an encapsulation thin film having the same polymer layer as that of the comparative example of Experiment 2. Comparative Example 2 of Experimental Example 3 is an encapsulation thin film having only the same hydrophilic polymer layer as that of Experimental Example 3 of Experiment 2. Comparative Example 3 of Experiment 3 is an encapsulation thin film including the same polymer layer as that of Comparative Example of Experiment 2 and an inorganic protective layer that is formed thereon. That is, the experimental example has a hydrophilic polymer layer and an inorganic protective layer that are cured by UV and ozone (03). Comparative Example 1 has only a polymer layer that is cured only by UV. Comparative Example 2 has only a hydrophilic polymer layer that is cured by UV and ozone. Comparative Example 3 has a polymer layer and an inorganic protective layer that are cured by only UV. As shown in FIG. 8, the moisture transmission rate of an encapsulation thin film including a hydrophilic polymer layer and an inorganic protective layer according to the exemplary embodiment is lowest.

Through the above-described experiments, it can be seen that the encapsulation thin film 200 according to the exemplary embodiment can most effectively suppress penetration of moisture or oxygen.

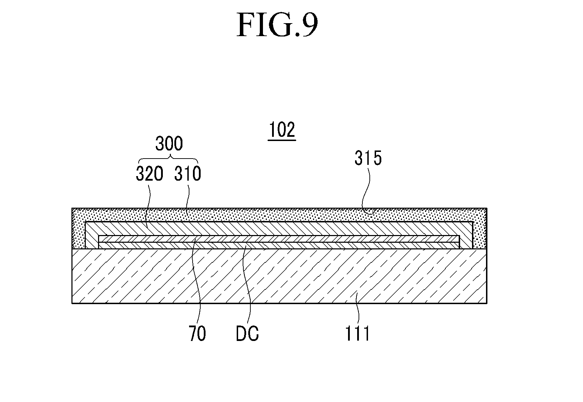

Hereinafter, an OLED display 102 according to an exemplary embodiment will be described with reference to FIG. 9. As shown in FIG. 9, the OLED display 102 has an encapsulation thin film 300 including an inorganic protective layer 320 that is directly formed on a substrate main body 111 to cover an OLED 70, and a hydrophilic polymer layer 310 that is directly formed on the inorganic protective layer 320.

The hydrophilic polymer layer 310 includes a hydrophilic surface 315 having an angle of contact within a range of larger than 0° and smaller than or equal to 50°. Further, a surface roughness of the hydrophilic surface 315 of the hydrophilic polymer layer 310 has an RMS within a range of larger than 0nm and smaller than 3nm. By such a structure, the OLED display 102 can effectively improve resistance to penetration of moisture or oxygen through the encapsulation thin film 300. Further, because the inorganic protective layer 320 is formed between the hydrophilic polymer layer 310 and the OLED 70, the OLED 70 can be prevented from being damaged while forming the hydrophilic polymer layer 310.

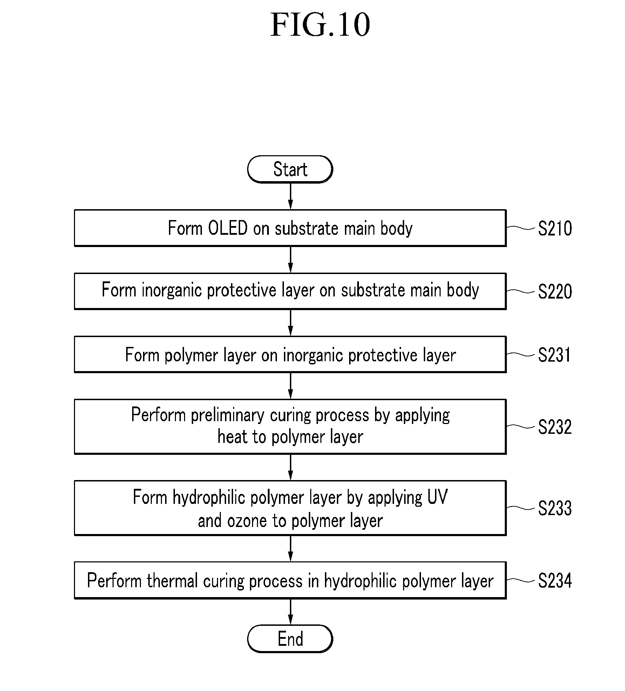

Hereinafter, a method of manufacturing an OLED display 102 of FIG. 9 will be described with reference to FIGS. 9 and 10. The driving circuit DC and the OLED 70 are formed on the substrate main body 111 (S210). The inorganic protective layer 320 is formed on the substrate main body 111 (S220) and covers OLED 70.

The inorganic protective layer 320 includes or consists of at least one of aluminum oxide (Al₂0₃), silicon oxide (SiO₂), silicon nitride (SiNx), silicon nitrate (SiON), magnesium oxide (MgO), magnesium fluoride (MgF₂), indium oxide (In₂O₃), zinc oxide (ZnO), and tin oxide (SnO₂). The inorganic protective layer 320 is formed through an e-beam evaporation method or an ALD method. Accordingly, the inorganic protective layer 320 has a higher density to increase resistance to penetration of moisture and oxygen.

Next, a polymer layer is formed on the inorganic protective layer 320 (S231). The polymer layer is made of a material including or consisting of at least one of an acryl-based resin, an epoxy-based resin, polyimide, and polyethylene. The polymer layer is formed with a spin coating method. Therefore, the polymer layer has a flat surface.

By applying heat to the polymer layer, a preliminary curing process is performed (S232). Such a preliminary curing process may be omitted, as needed. Preliminary curing is performed using a hot plate. Specifically, preliminary curing is performed for a time period within a range of 2 minutes to 5 minutes at a temperature within a range of 60°C or 100°C.

Next, UV and ozone (O₃) are applied to the preliminarily-cured polymer layer that is preliminarily cured through UV and ozone radiation equipment (S233). In this case, UV rays have a wavelength within a range of 150nm to 280nm and energy within a range of 2000mJ/cm² to 3500mJ/cm². UV and ozone (O₃) are applied to the polymer layer for a time period within a range of 1.5 minutes to 15 minutes. In this way, the polymer layer that is cured by UV and ozone (O₃) becomes the hydrophilic polymer layer 310.

The UV and ozone radiation equipment can radiate first UV rays having a wavelength within a range of 180nm to 190nm and second UV rays having a wavelength within a range of 248nm to 259nm. The first UV rays generate oxygen atoms (O) by decomposing oxygen molecules (O₂), and the second UV rays generate ozone (O₃) by coupling oxygen atoms (O). That is, the first UV rays and the second UV rays that are emitted from the UV and ozone radiation equipment generate ozone (O₃) to be applied to the polymer layer while directly light-curing the polymer layer.

The hydrophilic polymer layer 310 is thermally cured using an oven (S234). The hydrophilic polymer layer 310 that is thermally cured in the oven is completely cured. Thermal curing is performed for 30 minutes to 30 hours at a temperature within a range of 100°C to 160°C.

Because the inorganic protective layer 320 is formed earlier than the hydrophilic polymer layer 310, the OLED 70 can be prevented from being damaged during the process of forming the hydrophilic polymer layer 310.

The hydrophilic polymer layer 310 that is formed in this way has an angle of contact within a range of larger than 0° and smaller than or equal to 50°. Further, the surface roughness of the hydrophilic polymer layer 310 has an RMS within a range of larger than 0nm and smaller than 3nm. The hydrophilic polymer layer 310 can have a relatively smooth surface and a low angle of contact. Therefore, the hydrophilic polymer layer 310 improves resistance to penetration of moisture and oxygen.

By such a manufacturing method, the OLED display 102 including the encapsulation thin film 300 in which resistance to penetration of moisture or oxygen is effectively improved can be manufactured.

## Claims

1. An organic light emitting diode (OLED) display (101, 102) comprising:
a substrate main body (111);
an OLED (70) that is formed on the substrate main body (111); and
an encapsulation thin film (200, 300) comprising or consisting of:
(i) a hydrophilic polymer layer (210) that is formed on the substrate main body (111) and covers the OLED (70), the hydrophilic polymer layer (210) comprising a hydrophilic surface (215) having an angle of contact within a range of larger than 0° and smaller than or equal to 50°;and
an inorganic protective layer (220) that is formed on the hydrophilic surface (215) of the hydrophilic polymer layer (210); or
(ii) an inorganic protective layer (320) that is formed on the substrate main body (111) and covers the OLED (70); and
a hydrophilic polymer layer (310) that is formed on the inorganic protective layer (320), the hydrophilic polymer layer (310) comprising a hydrophilic surface (315) having an angle of contact within a range of larger than 0° and smaller than or equal to 50°.

2. The OLED display of claim 1, wherein the hydrophilic surface (215, 315) of the hydrophilic polymer layer (210, 310) has a surface roughness with a root mean square (RMS) within a range of larger than 0nm and smaller than 3nm.

3. The OLED display of claims 1 or 2, wherein the hydrophilic polymer layer (210, 310) comprises or consists of at least one of an acryl-based resin, an epoxy-based resin, polyimide, and polyethylene.

4. The OLED display of any of the preceding claims, wherein the inorganic protective layer (220, 320) comprises or consists of at least one of aluminum oxide (Al₂O₃), silicon oxide (SiO₂), silicon nitride (SiNx), silicon nitrate (SiON), magnesium oxide (MgO), magnesium fluoride (MgF₂), indium oxide (In₂O₃), zinc oxide (ZnO), and tin oxide (SnO₂).

5. A method of manufacturing an organic light emitting diode (OLED) display (101, 102) of any one of claims 1 through 4, the method comprising:
preparing a substrate main body (111);
forming an OLED (70) on the substrate main body (70); and
forming an encapsulation thin film (200, 300) by
(i) forming a polymer layer that covers the OLED (70) on the substrate main body (111); forming a hydrophilic polymer layer (210) having a hydrophilic surface (215) by applying UV rays and ozone (O₃) to the formed polymer layer through UV and ozone radiation equipment;
thermal curing the formed hydrophilic polymer layer (210); and
forming an inorganic protective layer (220) on the thermally-cured hydrophilic surface (215) of the hydrophilic polymer layer (210); or
(ii) forming an inorganic protective layer (320) that covers the OLED (70) on the substrate main body (111);
forming a polymer layer on the formed inorganic protective layer (320);
forming a hydrophilic polymer layer (310) having a hydrophilic surface (315) by applying UV rays and ozone (O₃) to the formed polymer layer through UV and ozone radiation equipment; and
thermal curing the formed hydrophilic polymer layer (310).

6. The method of claim 5, wherein the UV rays have a wavelength within a range of 150nm to 280nm.

7. The method of claim 6, wherein the UV rays have energy within a range of 2000mJ/cm² to 3500mJ/cm².

8. The method of claims 6 or 7, wherein the UV rays and the ozone (O₃) are applied to the polymer layer for a time period within a range of 1.5 minutes to 15 minutes.

9. The method of any one of claims 6 through 8, wherein the UV rays and ozone radiation equipment radiates first UV rays having a wavelength within a range of 180nm to 190nm and second UV rays having a wavelength within a range of 248nm to 259nm.

10. The method of any one of claims 5 through 9, wherein the UV rays and the ozone that are generated in the UV and ozone radiation equipment etch a surface of the polymer layer with an average speed within a range of 1 nm/min to 10nm/min.

11. The method of any one of claims 5 through 10, wherein the thermal curing is performed for 30 minutes to 30 hours at a temperature within a range of 100°C to 160°C.

12. The method of any one of claims 5 through 11, wherein the polymer layer is formed with a spin coating method.

13. The method of any one of claims 5 through 12, wherein the inorganic protective layer (220, 320) is formed through an electron beam evaporation method or an atomic layer deposition (ALD) method.

14. The method of any one of claims 5 through 13, further comprising preliminarily curing the polymer layer.

15. The method of claim 14, wherein the preliminary curing is performed for a time period within a range of 2 minutes to 5 minutes at a temperature within a range of 60°C to 100°C.
